# EUROPÄISCHE PATENTSCHRIFT

(11) **EP 3 487 072 B1**
(45) Veröffentlichungstag und Bekanntmachung des Hinweises auf die Patenterteilung: **26.05.2021**
(21) Anmeldenummer: 18206510.2
(22) Anmeldetag: 15.11.2018
(51) Int. Cl.: H03K 5/06, H03K 17/60, H03K 3/86

(54) **PULSERZEUGUNGSVORRICHTUNG**
PULSE GENERATION DEVICE
DISPOSITIF DE GÉNÉRATION D'IMPULSIONS

(30) Priorität: 21.11.2017 DE 102017127505
(43) Veröffentlichungstag der Anmeldung: 22.05.2019
(73) Patentinhaber: SICK AG, 79183 Waldkirch (DE)
(72) Erfinder: Baldischweiler, Boris, 79194 Gundelfingen (DE)
(74) Vertreter: Manitz Finsterwald Patent- und Rechtsanwaltspartnerschaft mbB

(56) Entgegenhaltungen:
- US-A- 4 928 248
- US-A1- 2005 225 371

## Beschreibung

Die vorliegende Erfindung betrifft eine Pulserzeugungsvorrichtung, die zur Erzeugung von elektrischen Pulsen mit Pulsdauern im Bereich von Nanosekunden ausgebildet ist. Die von der Pulserzeugungsvorrichtung ausgegebenen elektrischen Pulse weisen Logikpegel auf, d.h. die Pulse sind mit Logikschaltungen kompatibel. Alternativ besitzen die Pulse Spannungsamplituden im Bereich von Kleinspannungen.

Die US 2005/0225371 A1 offenbart eine Pulserzeugungsvorrichtung gemäß dem Oberbegriff des Anspruchs 1. Die US 2 769 101 A betrifft die Erzeugung von Hochspannungspulsen. Schließlich lehrt die US 2011/0254594 A1 die Umwandlung elektrischer Energie. In keinem dieser Dokumente ist eine Offenbarung enthalten, die eine Laserdiode als Anpasselement betrifft oder einen Hinweis auf eine solche gibt. Eine Laserdiode, die mit dem Ausgangssignal einer Pulserzeugungsvorrichtung betrieben wird, ist in der US 4 928 248 A beschrieben.

Eine Pulserzeugungsvorrichtung, welche in Speichersystemen eines Computers eingesetzt werden kann, ist aus der US 3 386 036 bekannt. Dort wird eine Verzögerungsleitung zusammen mit UND-Gattern verwendet, um kurze Pulse zu erzeugen.

Nachteilig an solchen bekannten Pulserzeugungsvorrichtungen ist, dass eine relativ große Länge der Verzögerungsleitung benötigt wird, was zu einer relativ großen Pulserzeugungsvorrichtung führt. Zudem ist die zeitliche Länge der erzeugten Pulse aufgrund von Bauteiltoleranzen nur mit großem Aufwand exakt einstellbar bzw. kontrollierbar.

Zudem können Bauteile zur Anpassung eines Wellenwiderstands notwendig sein, die zusätzlich Bauraum benötigen.

Es ist daher die der Erfindung zugrundeliegende Aufgabe, eine kompakte und einfach herzustellende Pulserzeugungsvorrichtung anzugeben, welche Pulse mit einer insbesondere exakt einstellbaren zeitlichen Länge erzeugt.

Diese Aufgabe wird durch eine Pulserzeugungsvorrichtung gemäß Anspruch 1 gelöst.

Die erfindungsgemäße Pulserzeugungsvorrichtung ist ausgebildet, elektrische Pulse mit Pulsdauern im Bereich von Nanosekunden zu erzeugen, wobei die elektrischen Pulse Spannungen mit einem Betrag bis zu 60 V und/oder Ströme von weniger als 20 A aufweisen. Die erfindungsgemäße Pulserzeugungsvorrichtung umfasst eine Signalquelle, welche ein Eingangssignal bereitstellt, und ein mit der Signalquelle elektrisch gekoppeltes Verzögerungsglied, welches ein an das Verzögerungsglied angelegtes Signal beim Durchlaufen des Verzögerungsglieds um eine vorbestimmte Zeitdauer verzögert. Die Pulserzeugungsvorrichtung umfasst weiterhin ein Reflexionsmittel, welches das Verzögerungsglied durchlaufende elektrische Signale reflektiert. Schließlich ist ein Signalausgang zur Ausgabe der elektrischen Pulse vorgesehen, welcher elektrisch mit dem Verzögerungsglied verbunden ist.

Gemäß Anspruch 1 ist ein Anpasselement vorhanden, welches eine Anpassung des Widerstands der Signalquelle und/oder des Reflexionsmittels an den Wellenwiderstand des Verzögerungsglieds bewirkt. Gemäß Anspruch 1 umfasst das Anpasselement eine Laserdiode.

Die erfindungsgemäße Pulserzeugungsvorrichtung kann also eine Reihenschaltung der Signalquelle, des Verzögerungsglieds und des Reflexionsmittels aufweisen. Beim Aktivieren der Signalquelle wird an einem Anschluss der Signalquelle zunächst das Eingangssignal bereitgestellt. Das Eingangssignal wird an das Verzögerungsglied übertragen, wobei das Eingangssignal das Verzögerungsglied durchläuft. Beispielsweise nach dem Durchlaufen des Verzögerungsglieds wird das Eingangssignal von dem Reflexionsmittel reflektiert (insbesondere mit invertierter Phase) und läuft durch das Verzögerungsglied zurück, wobei dann am Eingang des Verzögerungsglieds (d.h. an demjenigen Anschluss des Verzögerungsglieds, der mit der Signalquelle gekoppelt ist) das Eingangssignal durch das reflektierte Signal aufgrund der invertierten Phasenlage ausgelöscht werden kann. Am Eingang des Verzögerungsglieds liegt also nur sehr kurze Zeit ein Signal an, und zwar insbesondere so lange, bis das Verzögerungsglied zwei Mal durchlaufen wurde und das Eingangssignal durch das reflektierte Signal ausgelöscht wird. Die Zeitdauer, wie lange das Signal vorliegt, kann über die Länge des Verzögerungsglieds bzw. die vorbestimmte Zeitdauer, um welche das Verzögerungsglied ein Signal verzögert (Verzögerungsdauer), eingestellt werden. Auf diese Weise lassen sich Pulse mit Pulsdauern im Bereich von Nanosekunden (z.B. 0,05 bis 20 ns, bevorzugt 0,1 bis 10 ns, besonders bevorzugt 2 bis 5 ns) auf einfache Weise erzeugen.

Von Vorteil ist insbesondere, dass das Verzögerungsglied relativ klein und kompakt ausgebildet werden kann, da das Verzögerungsglied aufgrund des Reflexionsmittels zweifach durchlaufen wird und beispielsweise nur halb so "groß" sein muss, wie eine nur einmal durchlaufene Verzögerungsleitung.

Im Folgenden sollen weitere Aspekte der erfindungsgemäßen Pulserzeugungsvorrichtung noch detaillierter erläutert werden.

Bevorzugt ist das Reflexionsmittel mittels des Verzögerungsglieds mit der Signalquelle elektrisch verbunden. Dies bedeutet, es kann eine Reihenschaltung von Signalquelle, Verzögerungsglied und Reflexionsmittel (in der genannten Reihenfolge) vorliegen. Bei dem nachfolgend auch erwähnten inversen Aufbau der Pulserzeugungsvorrichtung kann das Reflexionsmittel auch zwischen der Signalquelle und dem Verzögerungsglied angeordnet sein oder sogar durch die Signalquelle selbst gebildet werden. Bei dem inversen Aufbau kann eine Reihenschaltung von Signalquelle, Reflexionsmittel und Verzögerungsglied (in der genannten Reihenfolge) vorliegen.

Weiter bevorzugt ist der Signalausgang jeweils auf der dem Reflexionsmittel gegenüberliegenden Seite des Verzögerungsglieds angeordnet. Der Signalausgang und das Reflexionsmittel können mittels des Verzögerungsglieds elektrisch miteinander verbunden sein. Anders ausgedrückt kann eine Reihenschaltung von Signalausgang, Verzögerungsglied und Reflexionsmittel (in der genannten Reihenfolge) vorliegen.

Die von der Pulserzeugungsvorrichtung ausgegebenen Pulse können Logikpegel aufweisen, dies bedeutet, dass die Spannung und/oder der Strom des jeweiligen Pulses mit Logikschaltungen kompatibel ist. Beispielsweise kann eine Kompatibilität mit TTL-Logik, mit CMOS-Logik oder mit Low-Voltage-CMOS-Logik implementiert sein. Insbesondere können die ausgegebenen Pulse (d.h. ein Ausgangssignal an dem Signalausgang) einen Spannungsbetrag z.B. zwischen 2 und 5 V, bevorzugt bis zu 5 V, besonders bevorzugt bis zu 3,3 V aufweisen. Erfindungsgemäß sind Spannungen mit einem Betrag bis 60 V und/oder Ausgangsströme von weniger als 20 A vorgesehen.

Wie erwähnt, kann eine Reihenschaltung von Signalquelle, Verzögerungsglied und Reflexionsmittel verwendet werden. Der Signalausgang kann dabei insbesondere durch die elektrische Verbindung von Signalquelle und Verzögerungsglied gebildet sein.

Das Reflexionsmittel kann beispielsweise durch ein geschlossenes Ende einer elektrischen Leitung gebildet sein, d.h. das Reflexionsmittel umfasst eine elektrische Verbindung auf ein Bezugspotential, insbesondere auf Masse. Hierzu kann ein Anschluss des Verzögerungsglieds, welcher dem mit der Signalquelle verbundenen Eingang des Verzögerungsglieds gegenüberliegt, z.B. direkt mit Masse verbunden sein. Alternativ kann das Reflexionsmittel auch ein offenes Ende einer elektrischen Leitung umfassen, wobei ein Ausgang des Verzögerungsglieds insbesondere unbeschaltet bleiben kann oder mittels eines Widerstands von mehreren Megaohm, z.B. mit Masse verbunden wird.

Das Verzögerungsglied umfasst insbesondere eine elektrische Leitung mit einer vorbestimmten Länge, wobei die Verzögerungsdauer die Zeitdauer ist, die ein elektrisches Signal zum Durchlaufen der Leitung benötigt. Als Eingang des Verzögerungsglieds wird dabei dasjenige Ende der Leitung angesehen, das mit der Signalquelle elektrisch verbunden ist. Als Ausgang des Verzögerungsglieds wird dementsprechend das dem Eingang gegenüberliegende Ende des Verzögerungsglieds angesehen.

Bei der elektrischen Leitung kann es sich beispielsweise um eine Koaxial-Leitung handeln.

Bevorzugt ist die Pulserzeugungsvorrichtung vollständig auf einer einzelnen Leiterplatte (printed circuit board - PCB) angeordnet. Hierdurch kann ebenfalls die kompakte Ausbildung der Pulserzeugungsvorrichtung unterstützt werden.

Mit der erfindungsgemäßen Pulserzeugungsvorrichtung können bevorzugt auch Einzelpulse erzeugt werden. Dies bedeutet eine Zeitdauer (Pause) zwischen einzelnen Pulsen ist länger als die Pulsdauer. Bevorzugt ist die Zeitdauer zwischen einzelnen Pulsen zehn Mal oder einhundert Mal länger als die Pulsdauer.

Es versteht sich, dass in diesem Kontext unter einer Verbindung bzw. Kopplung und/oder einem Signal jeweils eine elektrische Verbindung bzw. Kopplung und/oder ein elektrisches Signal gemeint ist, sofern nicht explizit anders angegeben.

Vorteilhafte Weiterbildungen der Erfindung sind in der Beschreibung, den Figuren und den Unteransprüchen angegeben.

Gemäß einer ersten vorteilhaften Ausführungsform ist der Signalausgang mit einem Pegelwandler gekoppelt, insbesondere mit einem Logikgatter. Der Pegelwandler kann insbesondere aus der HCT-Logikfamilie stammen. Diese Logikfamilie interpretiert bereits ein Spannungssignal von etwa 40% der Nennspannung als ein positives Signal (bei 5 V Logikpegel wird bereits ein Signal von 2 V als "high" angesehen). Durch die Verwendung eines Pegelwandlers kann an dem Signalausgang zuverlässig ein kompatibler Logikpegel ausgegeben werden, was die Weiterverarbeitung des Pulses in einer Logikschaltung erleichtert.

Eine an den Signalausgang angeschlossene elektrische Schaltung oder ein dort angeschlossener Pegelwandler ist bevorzugt hochohmig im Vergleich zu dem Wellenwiderstand des Verzögerungsglieds. Insbesondere weist der Pegelwandler oder die angeschlossene elektrische Schaltung einen Eingangswiderstand auf, welcher zumindest 10 oder 100 mal größer ist als der Wellenwiderstand des Verzögerungsglieds.

Gemäß einer weiteren vorteilhaften Ausführungsform wird ein geschlossenes Ende durch eine elektrische Verbindung mit einem Referenzpotential geschaffen, wobei sich das Referenzpotential von dem Massepotential unterscheidet. Bevorzugt liegt das Referenzpotential höher, insbesondere um zumindest 1 V höher, als das Massepotential. Durch das erhöhte Referenzpotential können sich die Spannungen an dem Signalausgang derart einstellen, dass an den Signalausgang auch direkt Standard-Logikgatter angeschlossen werden können. Der vorstehend genannte Pegelwandler kann dementsprechend auch eine CMOS-Schaltung und/oder eine TTL-Schaltung oder generell eine Standard-Logik-Schaltung umfassen.

Gemäß einer weiteren vorteilhaften Ausführungsform umfasst das Verzögerungsglied eine Leiterbahn, welche auf einer Leiterkarte und/oder in einem integrierten Schaltkreis (IC) angeordnet ist. Wie bereits kurz erwähnt, definiert die Leiterbahn über die Länge ihrer Wegstrecke die zeitliche Länge der Pulse. Beispielsweise kann die Leiterbahn des Verzögerungsglieds eine Länge zwischen 2 und 100 cm, bevorzugt zwischen 5 und 50 cm, weiter bevorzugt zwischen 5 und 20 cm, besonders bevorzugt 8,5 cm aufweisen. Dabei ermöglicht die Anordnung auf einer Leiterkarte eine einfache Herstellbarkeit der Pulserzeugungsvorrichtung und eine einfache Integration, z.B. in bereits bestehende Logikschaltungen. Die Leiterbahn kann zumindest bereichsweise oder vollständig geradlinig und/oder zumindest bereichsweise oder vollständig mäanderförmig ausgebildet sein. Die Leiterbahn des Verzögerungsglieds kann insbesondere im Inneren der Leiterkarte, beispielsweise zwischen zwei Masseflächen, angeordnet sein. Alternativ kann die Leiterbahn des Verzögerungsglieds auch auf der Oberfläche der Leiterkarte angeordnet sein, wobei links und rechts (beidseitig) der Leiterbahn jeweils Masseflächen angeordnet sein können (sogenannte Koplanartechnik). Auch ist es möglich, dass das Verzögerungsglied eine Koaxialleitung umfasst.

Gemäß einer weiteren vorteilhaften Ausführungsform ist die Zeitdauer einstellbar, um welche das Verzögerungsglied durchlaufende Signale verzögert. Bevorzugt können hierzu mehrere Reflexionsmittel vorgesehen sein, welche wahlweise elektrisch mit dem Verzögerungsglied verbindbar sind. Jeweils genau eines der Reflexionsmittel kann elektrisch zu einer Zeit mit dem Verzögerungsglied gekoppelt sein, wobei das jeweils elektrisch verbundene Reflexionsmittel das Verzögerungsglied durchlaufende Signale reflektiert. Anders ausgedrückt werden entlang des Verzögerungsglieds mehrere Reflexionsmittel angeordnet, von welchen jeweils eines wahlweise verwendet wird.

Die verschiedenen Reflexionsmittel können an unterschiedlichen Positionen entlang des Verzögerungsglieds angeordnet sein, wodurch verschiedene Verzögerungsdauern ausgewählt werden können. Beispielsweise können entlang des Verzögerungsglieds mehrere Kontaktpunkte für "Jumper" angeordnet sein, so dass durch Setzen des Jumpers die effektive Länge des Verzögerungsglieds einstellbar ist. Die effektive Länge des Verzögerungsglieds ist dann die Länge von dem Eingang des Verzögerungsglieds bis zu dem jeweils gesetzten Jumper. Der Jumper kann bevorzugt die Leiterbahn des Verzögerungsglieds mit einem Bezugspotential (z.B. Masse) verbinden.

Alternativ können entlang des Verzögerungsglieds auch mehrere Schalter angeordnet sein, die an unterschiedlichen Stellen eine elektrische Verbindung des Verzögerungsglieds mit einem Bezugspotential ermöglichen. Bei den Schaltern kann es sich beispielsweise um Relais, Bipolar-Transistoren oder Feldeffekttransistoren handeln. Die Verwendung solcher Schalter bietet den Vorteil, dass die Verzögerungsdauer des Verzögerungsglieds im Betrieb der Pulserzeugungsvorrichtung veränderbar ist und sich somit die Pulsdauer der von der Pulserzeugungsvorrichtung ausgegebenen Pulse ebenfalls im Betrieb verändern und einstellen lässt.

Weiter alternativ kann ein gleitend mechanisch bewegter elektrischer Kontakt verwendet werden, welcher es ermöglicht, an unterschiedlichen Positionen des Verzögerungsglieds eine Reflexion des das Verzögerungsglied durchlaufenden Signals zu bewirken. Hierzu kann der gleitend bewegte Kontakt eine elektrische Verbindung an einer wählbaren Position des Verzögerungsglieds mit einem Bezugspotential (z.B. Masse) herstellen. Durch den gleitend bewegten mechanischen Kontakt ist sogar eine stufenlose Einstellung der Verzögerungsdauer und damit der Pulsdauer möglich.

Erfindungsgemäß ist die Signalquelle eine Spannungsquelle. Eine Spannungsquelle liefert im Betrieb eine vorbestimmte Spannung, wohingegen eine Stromquelle im Betrieb einen vorbestimmten Strom einprägt. Je nach Anwendungsfall kann eine Spannungsquelle oder eine Stromquelle benötigt werden. Hierbei ist zu beachten, dass bei einer Reflexion am offenen Ende eine Stromwelle mit negativem Vorzeichen (d.h. mit invertierter Phase) und eine Spannungswelle mit positivem Vorzeichen (d.h. mit gleicher Phase) zurückgeworfen wird. In entsprechender Weise wird bei einer Reflexion am geschlossenen Ende (Reflexion am Kurzschluss) eine Stromwelle mit positivem Vorzeichen und eine Spannungswelle mit negativem Vorzeichen zurückgeworfen. Je nach Anwendungsfall muss also das Reflexionsmittel entsprechend gewählt werden. Beispielsweise kann bei Verwendung einer Spannungsquelle als Signalquelle ein Kurzschluss als Reflexionsmittel verwendet werden, um nach dem doppelten Durchlaufen des Verzögerungsglieds ein Auslöschen des Eingangssignals am Eingang des Verzögerungsglieds zu bewirken. Auch könnte stattdessen eine Stromquelle verwendet werden. Abhängig von der Wahl des Reflexionsmittels (offenes oder geschlossenes Ende) kann entweder ein Spannungs- oder ein Strompuls erzeugt werden.

Dementsprechend kann das Reflexionsmittel einen Kurzschluss oder ein offenes Leitungsende umfassen. Bei dem Kurzschluss wird bevorzugt eine niederohmige Verbindung mit Masse hergestellt. Beim offenen Leitungsende besteht gar keine oder eine sehr hochohmige (z.B. > 1 kΩ, > 10 kΩ, > 100 kΩ oder > 1 MΩ) Verbindung mit Masse.

Gemäß einer weiteren vorteilhaften Ausführungsform ist die Signalquelle, bevorzugt ausschließlich, kapazitiv mit dem Verzögerungsglied verbunden. Dies bedeutet, ein Kondensator kann zwischen die Signalquelle und das Verzögerungsglied geschaltet sein. Es kann also eine Reihenschaltung von Signalquelle, Kondensator und Verzögerungsglied vorliegen. Die Signalquelle kann auf diese Weise kapazitiv entkoppelt sein. Hierdurch kann eine Verringerung der Belastung der Signalquelle erreicht werden, da die Signalquelle keinen Dauerstrom durch das Verzögerungsglied treiben muss. Parallel zu dem Kondensator zwischen Signalquelle und Verzögerungsglied kann auch ein hochohmiger Widerstand (z.B. > 10 kΩ oder > 100 kΩ) geschaltet sein. Durch den parallel geschalteten Widerstand kann sich das Verzögerungsglied über längere Zeitperioden auf dem gleichen Pegel / Potential befinden, wie die Signalquelle.

Gemäß einer weiteren vorteilhaften Ausführungsform ist ein Anpasselement vorgesehen, welches eine Anpassung des Widerstands der Signalquelle und/oder des Reflexionsmittels an den Wellenwiderstand des Verzögerungsglieds bewirkt. Das Anpasselement kann beispielsweise einen elektrischen Widerstand umfassen (z.B. mit 50 Ω), welcher bevorzugt zwischen die Signalquelle und das Verzögerungsglied geschaltet ist.

Es kann also eine Reihenschaltung von Signalquelle, Anpasselement und Verzögerungsglied vorliegen. Die Verwendung beispielsweise eines Widerstands mit 50 Ω kann die Signalquelle und/oder das Reflexionsmittel an einen Wellenwiderstand von ebenfalls 50 Ω des Verzögerungsglieds anpassen. Das Anpasselement kann auch den Innenwiderstand der Signalquelle umfassen. Dementsprechend kann ein zusätzlich zwischen Signalquelle und Verzögerungsglied vorgesehener Widerstand kleiner als der Wellenwiderstand des Verzögerungsglieds ausfallen (z.B. 40 Ω, sofern die Signalquelle einen Innenwiderstand von 10 Ω aufweist).

Im Folgenden wird beispielhaft eine Pulserzeugungsvorrichtung mit einer Spannungsquelle (Signalquelle, welche eine Spannung von 5 V erzeugt) betrachtet, wobei die Spannungsquelle in Serie mit einem 50 Ω Widerstand (Anpasselement) und einem Verzögerungsglied mit einem nicht angeschlossenen Ausgang verschaltet ist. In dieser Konstellation stellt sich beim Aktivieren der Spannungsquelle aufgrund der gleichen Widerstände von Anpasselement und Verzögerungsglied eine Spannung von jeweils 2,5 V an dem Anpasselement und an dem Verzögerungsglied ein.

Zugleich durchläuft das Signal der Signalquelle (mit 2,5 V) das Verzögerungsglied und wird an dessen kurzgeschlossenem Ende mit Vorzeichenwechsel reflektiert. Nach dem Zurücklaufen durch das Verzögerungsglied löscht das somit invertierte Signal (-2,5 V) die Spannung am Anpasselement aus, so dass die Spannung am Anpasselement nur wenige Nanosekunden vorliegt. Die Spannung am Anpasselement kann ausgegeben werden, insbesondere mittels eines HCT-Logikgatters, wodurch das Logikgatter für wenige Nanosekunden ein High-Signal ausgibt.

Gemäß einer weiteren vorteilhaften Ausführungsform umfasst das Anpasselement einen Schalter, wobei mittels des Schalters eine elektrische Verbindung mit einem Bezugspotential, insbesondere Masse, wahlweise herstellbar ist. Bei dieser Ausführungsform können das Anpasselement und der Schalter an den Ausgang des Verzögerungsglieds angeschlossen sein. Damit liegt das Verzögerungsglied zwischen dem Anpasselement und dem Schalter einerseits und der Signalquelle andererseits. Hierdurch kann ein inverser Aufbau geschaffen werden, wobei die Signalquelle zunächst ein Eingangssignal liefert. Um den Puls zu erzeugen, wird mittels des Schalters eine Verbindung mit Masse hergestellt, d.h. das an dem Ausgang des Verzögerungsglieds angeschlossene Anpasselement wird auf Masse gezogen. Hierdurch stellt sich eine Spannungsverteilung zwischen dem Anpasselement und dem Verzögerungsglied ein, wobei z.B. an dem Anpasselement und dem Verzögerungsglied jeweils die gleiche Spannung (z.B. 2,5 V) anliegt. Die Spannung am Ausgang des Verzögerungsglieds wird hierdurch (von z.B. 5 V auf 2,5 V) erniedrigt, woraufhin das Verzögerungsglied von dem erniedrigten Spannungssignal durchlaufen wird, welches dann von der Signalquelle reflektiert wird. Nach dem nochmaligen Durchlaufen des Verzögerungsglieds kehrt die Spannung am Ausgang des Verzögerungsglieds auf die Spannung zurück, die vor dem Schließen des Schalters anlag (z.B. 5 V). Es wurde auf diese Weise ein kurzer Puls erzeugt, wobei der Puls durch einen Spannungsabfall am Signalausgang gebildet wird. Der Signalausgang der Pulserzeugungsvorrichtung ist bei der inversen Ausführungsform am Ausgang des Verzögerungsglieds angeordnet, d.h. zwischen dem Verzögerungsglied und dem Anpasselement.

Bei dem inversen Aufbau kann die Signalquelle bevorzugt dauerhaft aktiviert sein. Ein jeweiliger Puls kann beim inversen Aufbau durch Durchschalten bzw. aktivieren des Schalters ausgelöst werden. Das Anpasselement kann auch einen Verbraucher umfassen oder von dem Verbraucher gebildet sein, wobei dem Verbraucher der erzeugte elektrische Puls zugeführt wird.

Bei dem inversen Aufbau mit einer Spannungsquelle kann der Innenwiderstand der Spannungsquelle im Vergleich zu dem Verzögerungsglied deutlich kleiner sein (beispielsweise zumindest 10 mal kleiner als der Wellenwiderstand des Verzögerungsglieds), um eine Reflexion an der Spannungsquelle zu ermöglichen. Die Spannungsquelle dient hierbei gleichzeitig als Reflexionsmittel, wobei eine Reflexion am "geschlossenen Ende" erfolgt.

Bei der Verwendung einer Stromquelle mit dem inversen Aufbau kann der Innenwiderstand der Stromquelle im Vergleich zu dem Wellenwiderstand des Verzögerungsglieds möglichst hoch gewählt werden, beispielsweise zumindest 10 oder 100 mal so groß. Hierdurch kann auch die Stromquelle als Reflexionsmittel verwendet werden, wobei durch den hohen Innenwiderstand der Stromquelle eine Reflexion am "offenen Ende" erfolgt.

Gemäß einer weiteren vorteilhaften Ausführungsform umfasst das Anpasselement eine Leuchtdiode. Zusätzlich kann das Anpasselement auch einen ohmschen Widerstand und/oder eine nicht-leuchtende Diode umfassen, wobei die Größe des ohmschen Widerstands kleiner als der Wellenwiderstand des Verzögerungsglieds ist. Der ohmsche Widerstand kann auch entfallen. Die Laserdiode führt, alleine oder gegebenenfalls gemeinsam mit dem ohmschen Widerstand, eine Anpassung an den Wellenwiderstand des Verzögerungsglieds durch. Ist der ohmsche Widerstand vorhanden, so kann auch durch einen solchen Widerstand, der kleiner als der Wellenwiderstand des Verzögerungsglieds ist, eine Anpassung an den Wellenwiderstand des Verzögerungsglieds erfolgen, da die Laserdiode negative Ströme auslöscht. Das Anpasselement kann eine Reihenschaltung des ohmschen Widerstands und zumindest einer der genannten Dioden (nicht-leuchtende Diode, Leuchtdiode und/oder Laserdiode) umfassen. Das Anpasselement kann also den Verbraucher des durch die Vorrichtung erzeugten Strompulses umfassen. Durch die Verwendung einer Leuchtdiode bzw. einer Laserdiode in dem Anpasselement kann direkt in der Pulserzeugungsvorrichtung auch ein optischer Puls erzeugt werden, der von der Leuchtdiode bzw. der Laserdiode stammt. Die Leuchtdiode bzw. die Laserdiode wird hierfür mit einem elektrischen Puls im Bereich von Nanosekunden angesteuert. Bei der Laserdiode kann es sich bevorzugt um einen Oberflächenemitter oder um einen VCSEL (von "Vertical-Cavity Surface-Emitting Laser") handeln. Der von der Laserdiode oder der Leuchtdiode ausgesandte optische (Licht-)Puls kann bevorzugt kürzer sein, als der elektrische Puls. Beispielsweise kann ein optischer Puls mit einer Länge von etwa 100 ps erzeugt werden. Der kurze optische Puls kann mittels des Gain Switchs der Laserdiode erzielt werden. Ein zusätzlicher Vorteil des Einsatzes einer Diode oder Laserdiode als Anpasselement ist, dass die Diode oder Laserdiode durch ihr jeweils nichtlineares elektrisches Verhalten eine Reflexion am Verzögerungsglied unterdrückt. Um die Reflexion zu unterdrücken ist bevorzugt die Impedanz des Verzögerungsglieds größer als die Impedanz der Diode oder Laserdiode.

Bevorzugt kann bei der Verwendung eines Anpasselements mit einer Leucht- oder Laserdiode der Wellenwiderstand des Verzögerungsglieds reduziert werden, beispielsweise durch die Parallelschaltung von zwei oder mehreren Verzögerungsleitungen oder Verzögerungsgliedern.

Beispielsweise kann die Pulserzeugungsvorrichtung eine Reihenschaltung (in der genannten Reihenfolge) aus Signalquelle, Verzögerungsglied, einem Anpasswiderstand, Diode (z.B. Leucht- oder Laserdiode) und Schalter umfassen, wobei der Schalter wahlweise eine elektrische Verbindung zu einem Bezugspotential herstellt. Der Anpasswiderstand, die Diode und der Schalter bilden in diesem Fall gemeinsam das Anpasselement. Die Signalquelle kann zudem einen Innenwiderstand aufweisen, welcher als Reflexionsmittel dient.

Weiterhin betrifft die Erfindung eine Logikschaltung mit mehreren Logikgattern und einer Pulserzeugungsvorrichtung, wie vorstehend erläutert. Dabei wird ein von der Pulserzeugungsvorrichtung erzeugter Puls mittels zumindest eines Logikgatters verarbeitet. Die Pulserzeugungsvorrichtung und die Logikschaltung können bevorzugt auf derselben Leiterkarte angeordnet sein.

Zudem betrifft die Erfindung auch einen Laserscanner mit zumindest einer Laserquelle, wobei die Laserquelle bevorzugt eine Laserdiode ist und weiter bevorzugt mit von der Pulserzeugungsvorrichtung erzeugten Pulsen betrieben wird. Der Laserscanner kann ausgebildet sein, kurze Laserpulse in verschiedene Raumrichtungen abzugeben und rückgestrahltes Licht der Laserpulse zu empfangen. Der Laserscanner kann eine drehbare optische Einrichtung (z.B. einen drehbaren Spiegel) aufweisen, welcher die Laserpulse in unterschiedliche Raumrichtungen emittiert und rückgestrahltes Licht der Laserpulse empfängt. Durch die erfindungsgemäße Möglichkeit, auf einfache Weise sehr kurze elektrische Pulse zu erzeugen, kann auch der Laserscanner einfach und kompakt aufgebaut sein. Erfindungsgemäß wird die hierin beschriebene, als Anpasselement genutzte Laserdiode als Laserquelle des Laserscanners verwendet. Hierdurch kann der Laserscanner sehr kurze optische Pulse ausgeben, beispielsweise mit Pulsdauern von 100 ps oder 200 ps.

Die Erläuterungen zur erfindungsgemäßen Pulserzeugungsvorrichtung gelten für die erfindungsgemäße Logikschaltung und den erfindungsgemäßen Laserscanner entsprechend, insbesondere hinsichtlich Vorteilen und bevorzugten Ausführungsformen.

Nachfolgend wird die Erfindung rein beispielhaft unter Bezugnahme auf die Zeichnungen beschrieben. Es zeigen:
- Fig. 1: eine nicht erfindungsgemäße Pulserzeugungsvorrichtung zur Ausgabe eines Spannungspulses gemäß einer ersten Ausführungsform;
- Fig. 2: ein Ausgangssignal der Pulserzeugungsvorrichtung von Fig. 1;
- Fig. 3: eine nicht erfindungsgemäße Pulserzeugungsvorrichtung zur Ausgabe eines Spannungspulses gemäß einer zweiten Ausführungsform;
- Fig. 4: Ausgangssignale einer Pulserzeugungsvorrichtung mit unterschiedlichen Längen des Verzögerungsglieds;
- Fig. 5: eine nicht erfindungsgemäße Pulserzeugungsvorrichtung mit inversem Aufbau zur Erzeugung eines Spannungspulses gemäß einer dritten Ausführungsform;
- Fig. 6: ein Ausgangssignal der Pulserzeugungsvorrichtung von Fig. 5;
- Fig. 7: eine nicht erfindungsgemäße Pulserzeugungsvorrichtung zur Erzeugung eines Strompulses gemäß einer vierten Ausführungsform;
- Fig. 8: ein Ausgangssignal der Pulserzeugungsvorrichtung von Fig. 7;
- Fig. 9: eine nicht erfindungsgemäße Pulserzeugungsvorrichtung zur Erzeugung eines Strompulses gemäß einer inversen Anordnung nach einer fünften Ausführungsform; und
- Fig. 10: eine erfindungsgemäße Pulserzeugungsvorrichtung zur Erzeugung eines Strompulses in inverser Ausführung mit einer direkt angesteuerten Laserdiode (sechste Ausführungsform).

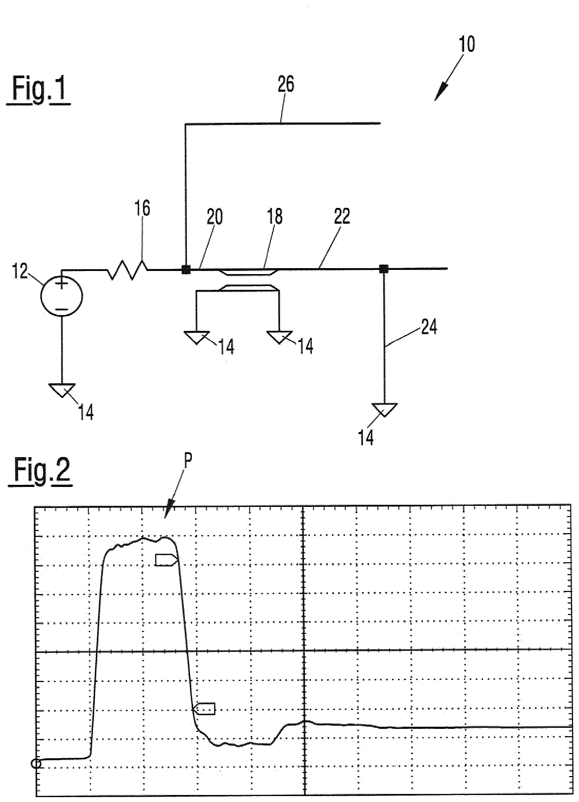

Fig. 1 zeigt eine erste Ausführungsform einer Pulserzeugungsvorrichtung 10. Die Pulserzeugungsvorrichtung 10 umfasst eine als Spannungsquelle 12 ausgebildete Signalquelle. Relativ zu einem Massepotential 14 erzeugt die Spannungsquelle 12 ein Eingangssignal mit beispielsweise 5 V. Die Spannungsquelle 12 ist mittels eines Anpasswiderstands 16 mit einer Verzögerungsleitung 18 elektrisch verbunden. Der Anpasswiderstand 16 dient als Anpasselement, und weist einen Widerstandswert von 50 Ω auf, welcher dem Wellenwiderstand der Verzögerungsleitung 18 entspricht. Der Anpasswiderstand 16 ist elektrisch mit einem Eingang 20 der Verzögerungsleitung gekoppelt. Die Verzögerungsleitung 18 besitzt eine Länge von etwa 8,5 cm und ist in Koplanartechnik auf einer Leiterkarte (nicht gezeigt) angeordnet. Ein Ausgang 22 des Verzögerungsglieds 18 ist elektrisch direkt mit dem Massepotential 14 verbunden, wobei die Verbindung mit dem Massepotential 14 als Reflexionsmittel 24 dient. In der Ausführungsform von Fig. 1 findet dabei eine Reflexion am geschlossenen Ende bzw. eine Reflexion am Kurzschluss statt.

Der elektrische Eingang 20 des Verzögerungsglieds bildet gleichzeitig auch einen Signalausgang 26, an welchem ein von der Pulserzeugungsvorrichtung 10 erzeugter Puls P ausgegeben wird.

Im Betrieb der Pulserzeugungsvorrichtung 10 bildet sich beim Einschalten der Spannungsquelle 12 eine Spannungsverteilung zwischen dem Anpasswiderstand 16 und der Verzögerungsleitung 18, wobei sich die Spannung der Spannungsquelle 12 aufgrund des gleichen Widerstands des Anpasswiderstands 16 und der Verzögerungsleitung 18 zu gleichen Teilen verteilt. Dies bedeutet, an dem Signalausgang liegt eine Spannung von etwa 2,5 V an. Die an der Verzögerungsleitung 18 anliegende Spannung von ebenfalls 2,5 V durchläuft die Verzögerungsleitung 18, wird an der Verbindung mit dem Massepotential 14, d.h. an dem Reflexionsmittel 24, reflektiert und invertiert und durchläuft die Verzögerungsleitung 18 in umgekehrter Richtung nochmals. Beim Zurückkehren mit umgekehrtem Vorzeichen wird die Spannung von 2,5 V am Signalausgang 26 ausgelöscht, wodurch die Spannung am Signalausgang 26 nach etwa 2 ns wieder auf etwa 0 V fällt. Auf diese Weise ist ein sehr kurzer Puls P im Bereich von wenigen Nanosekunden erzeugt worden, wobei der Puls P mit einer Amplitude von 2,5 V einen Logikpegel aufweist. Der Signalausgang 26 kann insbesondere einen Pegelwandler mit einer HCT-Logik aufweisen (nicht gezeigt), so dass durch den Pegelwandler das Signal von 2,5 V in ein weiteres Logiksignal mit beispielsweise 5 V Amplitude gewandelt werden kann.

Beim vorstehend erläuterten Betrieb der Pulserzeugungsvorrichtung 10 entsteht am Signalausgang 26 somit das in Fig. 2 gezeigte Ausgangssignal, das heißt ein Puls P. In Fig. 2 ist auf der X-Achse die Zeit in Nanosekunden (1 ns pro Abschnitt) aufgetragen. Auf der Y-Achse ist die Spannungsamplitude (0,3 V pro Abschnitt) angetragen.

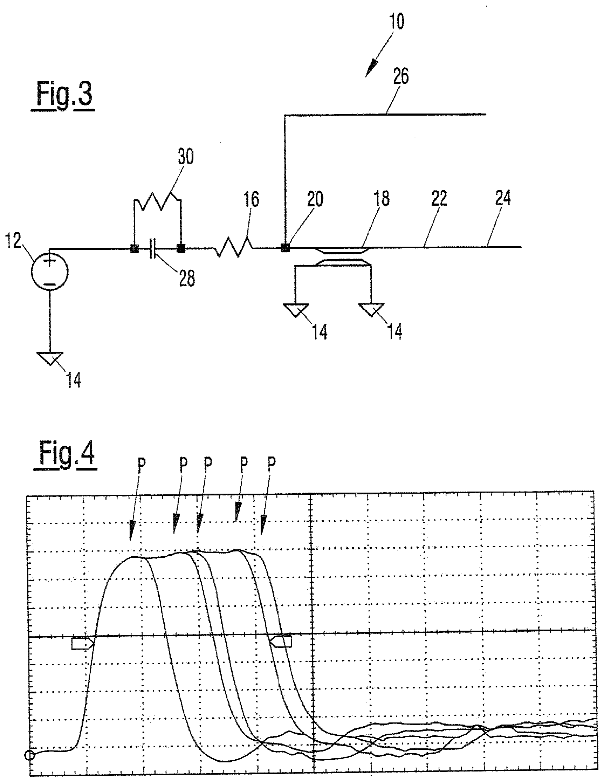

Fig. 3 zeigt eine zweite Ausführungsform der Pulserzeugungsvorrichtung 10. Die zweite Ausführungsform der Pulserzeugungsvorrichtung 10 unterscheidet sich von der Ausführungsform von Fig. 1 lediglich darin, dass zwischen der Spannungsquelle 12 und dem Anpasswiderstand 16 eine Parallelschaltung eines Entkopplungskondensators 28 und eines Entkopplungswiderstands 30 vorgesehen ist. Der Entkopplungskondensator 28 und der Entkopplungswiderstand 30 dienen dazu, die Leistungsbelastung der Spannungsquelle 12 im Dauerbetrieb zu verringern. Die Größe des Entkopplungswiderstands 30 kann zumindest 10, bevorzugt zumindest 20 mal größer sein, als die des Anpasswiderstands 16. Der Entkopplungskondensator kann eine Größe von etwa 0,5 bis 10 nF, bevorzugt 1 nF, aufweisen.

Das Reflexionsmittel 24 kann, wie vorstehend erläutert, wahlweise an verschiedenen Stellen der Verzögerungsleitung 18 elektrisch kontaktiert werden. Aufgrund der sich hierdurch ergebenden unterschiedlichen Längen der Verzögerungsleitung 18 können Pulse P mit unterschiedlichen Pulsdauern an dem Signalausgang 26 erzeugt werden. Solche unterschiedlichen Pulsdauern sind in Fig. 4 gezeigt, wobei in Fig. 4 (wie in Fig. 2) auf der X-Achse die Zeit in Nanosekunden und auf der Y-Achse die Spannung angetragen ist.

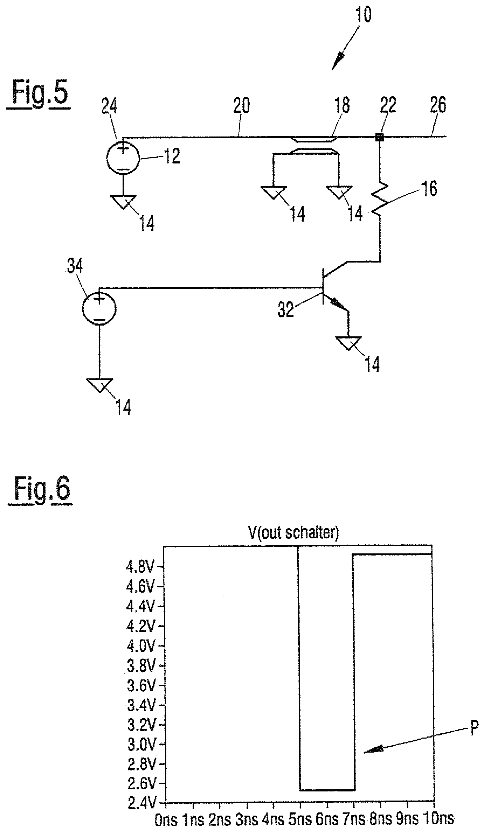

Fig. 5 zeigt eine dritte Ausführungsform der Pulserzeugungsvorrichtung 10. Die dritte Ausführungsform weist einen inversen Aufbau auf. Bei dieser Ausführungsform ist der Anpasswiderstand 16 an den Ausgang 22 der Verzögerungsleitung 18 angeschlossen. Der Anpasswiderstand 16 ist zudem über einen Transistor 32 wahlweise mit dem Massepotential 14 elektrisch verbindbar. Der Transistor 32 kann beispielsweise ein Bipolar-Transistor sein. Ebenfalls ist die Ausbildung als Feldeffekttransistor möglich. Der Transistor 32 wird von einer Steuerquelle 34 angesteuert.

Bei der dritten Ausführungsform weist die Spannungsquelle 12 einen geringen Innenwiderstand auf und dient damit als Reflexionsmittel 24. Im Betrieb der Pulserzeugungsvorrichtung 10 der dritten Ausführungsform liegt am Signalausgang 26, welcher sich hier am Ausgang 22 der Verzögerungsleitung 18 befindet, zunächst die von der Spannungsquelle 12 erzeugte Spannung an. Beim Schließen des Transistors 32 (d.h. beim Einschalten der Steuerquelle 34) wird der Anpasswiderstand 16 auf Massepotential 14 gezogen, wodurch die Spannung am Signalausgang 26 reduziert wird und beispielsweise auf die Hälfte absinkt. Hierdurch entsteht ein Signal, welches die Verzögerungsleitung 18 zunächst in Richtung der Spannungsquelle 12 durchläuft. Dieses Signal wird dann an der Spannungsquelle 12 reflektiert und durchläuft die Verzögerungsleitung 18 nochmals, so dass sich nach dem nochmaligen Durchlaufen der Verzögerungsleitung 18 an den Signalausgang 26 wieder das ursprüngliche Spannungsniveau einstellt. Hierdurch wurde ein kurzer Puls P im Bereich von Nanosekunden erzeugt, wobei der Puls P durch ein kurzes "Ausschalten" gebildet wird.

Der zeitliche Verlauf eines solchen Pulses P ist in Fig. 6 zu erkennen.

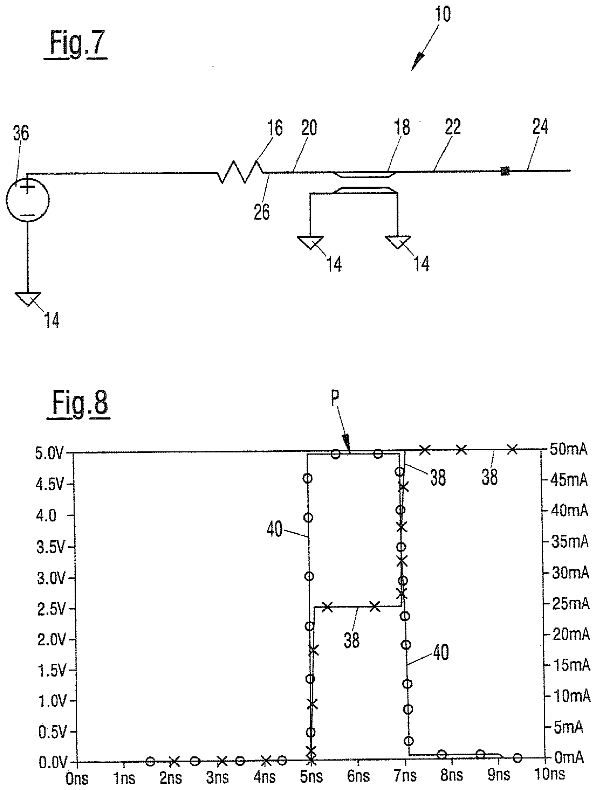

Eine vierte Ausführungsform der Pulserzeugungsvorrichtung 10 ist in Fig. 7 dargestellt. In der Fig. 7 ist die Signalquelle durch eine Spannungsquelle 36 realisiert. Das Reflexionsmittel 24 wird in der Ausführungsform von Fig. 7 durch ein offenes Leitungsende gebildet.

Im Betrieb der Pulserzeugungsvorrichtung 10 von Fig. 7 wird beim Einschalten der Spannungsquelle 36 eine Spannungs- / Stromwelle erzeugt, die zunächst den Anpasswiderstand 16 und anschließend die Verzögerungsleitung 18 durchläuft. Nach dem Durchlaufen der Verzögerungsleitung 18 wird die Stromwelle an dem offenen Ende des Reflexionsmittels 24 mit Vorzeichenwechsel reflektiert und durchläuft die Verzögerungsleitung 18 erneut. Nach dem erneuten Durchlaufen der Verzögerungsleitung 18 löscht die nun zurückkehrende Stromwelle die bisher existierende Stromwelle aus und beendet damit den so erzeugten Puls P. An dem Signalausgang 26 liegt dabei kurzzeitig (d.h. für die Länge des Pulses P) eine Spannung von etwa 2,5 V an. Nach dem Ende des Pulses P steigt diese Spannung auf 5 V. Während des Pulses P fließen etwa 50 mA durch den Anpasswiderstand 16. Nach der Pulsdauer von etwa 2 ns fließt nahezu kein Strom mehr durch den Anpasswiderstand 16. Der Anpasswiderstand 16 stellt hier einen Verbraucher dar und kann beispielsweise durch eine (nicht dargestellte) Verbrauchsschaltung ersetzt werden. Dies ist in Fig. 8 veranschaulicht, wobei in Fig. 8 ein stufenförmiges Spannungssignal 38 (durch Kreuze markiert) und ein rechteckförmiges Stromsignal 40 (durch Kreise markiert) dargestellt sind. Das Spannungssignal 38 zeigt den Verlauf der Spannung an dem Eingang 20 der Verzögerungsleitung 18 in Fig. 7. Das Stromsignal 40 gibt den Verlauf des Stroms durch den Anpasswiderstand 16 in Fig. 7 wieder.

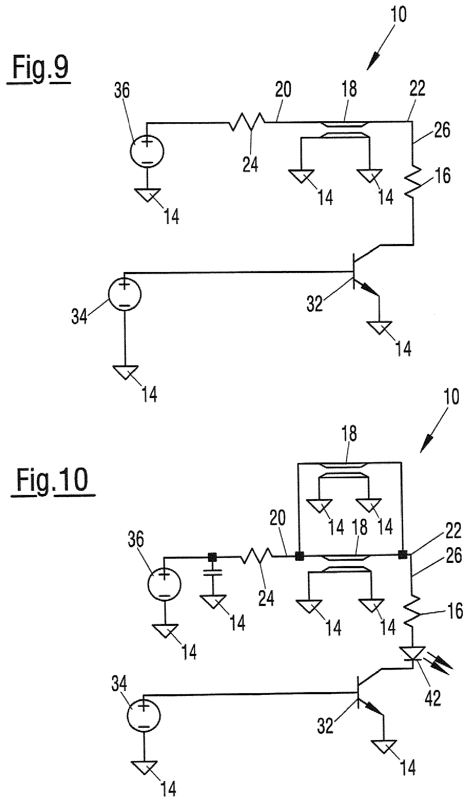

Fig. 9 zeigt eine fünfte Ausführungsform der Pulserzeugungsvorrichtung 10. Die fünfte Ausführungsform verwendet ebenfalls eine Spannungsquelle 36 als Signalquelle, ist im Vergleich zur Ausführungsform von Fig. 7 aber invers aufgebaut. Hierbei ist zwischen der Spannungsquelle 36 und der Verzögerungsleitung 18 ein Widerstand mit etwa 1 MΩ oder von etwa 10 kΩ als Reflexionsmittel 24 angeordnet. Der Widerstand kann auch Teil der Spannungsquelle 36 sein. Wie bei der Ausführungsform von Fig. 5 ist der Anpasswiderstand 16 an dem Ausgang 22 der Verzögerungsleitung 18 angeschlossen und über einen Transistor 32 mit dem Massepotential 14 verbindbar.

Beim Betrieb der Pulserzeugungsvorrichtung 10 gemäß Fig. 9 durchläuft ein beim Schließen des Transistors 32 im Anpasswiderstand 16 entstehendes Stromsignal zweimal die Verzögerungsleitung 18, wodurch ein kurzer Strompuls P erzeugt wird.

Fig. 10 zeigt eine sechste Ausführungsform der Pulserzeugungsvorrichtung 10. Die Pulserzeugungsvorrichtung 10 der Fig. 10 entspricht im Wesentlichen der Pulserzeugungsvorrichtung 10 von Fig. 9. Jedoch umfasst die Pulserzeugungsvorrichtung von Fig. 10 zwei parallel geschaltete Verzögerungsleitungen 18, so dass sich der effektive Wellenwiderstand der Verzögerungsleitungen 18 halbiert. Im Unterschied zu der Ausführungsform von Fig. 9 umfasst das Anpasselement eine Reihenschaltung von Anpasswiderstand 16 und einer Laserdiode 42. Das Reflexionsmittel 24 ist als Widerstand mit einem Widerstandswert von 10 kΩ ausgebildet, wobei das Reflexionsmittel 24 zwischen den Eingang 20 der Verzögerungsleitung 18 und die Spannungsquelle 36 geschaltet ist. Durch den beim Durchschalten des Transistors 32 (d.h. beim Aktivieren der Steuerquelle 34) entstehenden Strompuls P mit einer Länge von wenigen Nanosekunden kann direkt mittels der Laserdiode 42 ein optischer Puls mit einer Länge von ebenfalls wenigen Nanosekunden erzeugt werden. Hierdurch lassen sich auf einfache Weise z.B. die in Laserscannern benötigten kurzen Lichtpulse erzeugen. Zudem besitzt die Verwendung einer Diode den bereits weiter oben erläuterten Vorteil, dass der Anpasswiderstand 16 einen kleineren Widerstand als den Wellenwiderstand der beiden parallel geschalteten Verzögerungsleitungen 18 besitzen kann, als z.B. weniger als 25 Ω.

### Bezugszeichenliste

- 10: Pulserzeugungsvorrichtung
- 12: Spannungsquelle
- 14: Massepotential
- 16: Anpasswiderstand
- 18: Verzögerungsleitung
- 20: Eingang der Verzögerungsleitung
- 22: Ausgang der Verzögerungsleitung
- 24: Reflexionsmittel
- 26: Signalausgang
- 28: Entkopplungskondensator
- 30: Entkopplungswiderstand
- 32: Transistor
- 34: Steuerquelle
- 36: Spannungsquelle
- 38: Spannungssignal
- 40: Stromsignal
- 42: Laserdiode

- P: Puls

## Patentansprüche

1. Pulserzeugungsvorrichtung (10), ausgebildet zur Erzeugung von elektrischen Pulsen (P) mit Pulsdauern im Bereich von Nanosekunden, wobei die elektrischen Pulse (P) Spannungen mit einem Betrag bis zu 60 V und/oder Ströme von weniger als 20 A aufweisen, mit
einer Signalquelle (12), welche ein Eingangssignal bereitstellt,
einem mit der Signalquelle (12, 36) elektrisch gekoppelten Verzögerungsglied (18), welches ein an das Verzögerungsglied (18) angelegtes Signal beim Durchlaufen des Verzögerungsglieds (18) um eine vorbestimmte Zeitdauer verzögert,
einem Reflexionsmittel (24), welches das Verzögerungsglied (18) durchlaufende Signale reflektiert, und
einem Signalausgang (26) zur Ausgabe der elektrischen Pulse (P), welcher elektrisch mit dem Verzögerungsglied (18) verbunden ist,
wobei ein Anpasselement (16, 32, 42) vorhanden ist, welches eine Anpassung des Widerstands der Signalquelle (12, 36) und/oder des Reflexionsmittels (24) an den Wellenwiderstand des Verzögerungsglieds bewirkt, **dadurch gekennzeichnet, dass**
das Anpasselement eine Laserdiode (42) umfasst und die Signalquelle eine Spannungsquelle (12) ist.

2. Pulserzeugungsvorrichtung (10) nach Anspruch 1,
**dadurch gekennzeichnet, dass**
der Signalausgang (26) mit einem Pegelwandler, insbesondere einem Logikgatter, gekoppelt ist.

3. Pulserzeugungsvorrichtung (10) nach Anspruch 1 oder 2,
**dadurch gekennzeichnet, dass**
das Verzögerungsglied (18) eine Leiterbahn umfasst, welche auf einer Leiterkarte und/oder in einem Integrierten Schaltkreis (IC) angeordnet ist.

4. Pulserzeugungsvorrichtung (10) nach zumindest einem der vorstehenden Ansprüche, **dadurch gekennzeichnet, dass**
die Zeitdauer, um welche das Verzögerungsglied (18) durchlaufende Signale verzögert, einstellbar ist, wobei bevorzugt mehrere Reflexionsmittel (24) vorhanden sind, welche wahlweise elektrisch mit dem Verzögerungsglied (18) verbindbar sind und von welchen das jeweils elektrisch verbundene das Verzögerungsglied (18) durchlaufende Signale reflektiert.

5. Pulserzeugungsvorrichtung (10) nach zumindest einem der vorstehenden Ansprüche, **dadurch gekennzeichnet, dass**
das Reflexionsmittel (24) einen Kurzschluss oder ein offenes Leitungsende umfasst.

6. Pulserzeugungsvorrichtung (10) nach zumindest einem der vorstehenden Ansprüche, **dadurch gekennzeichnet, dass**
die Signalquelle (12, 36) kapazitiv mit dem Verzögerungsglied (18) verbunden ist.

7. Pulserzeugungsvorrichtung (10) nach zumindest einem der vorstehenden Ansprüche, **dadurch gekennzeichnet, dass**
das Anpasselement (16, 42) einen Schalter (32) umfasst, wobei mittels des Schalters (32) eine elektrische Verbindung mit Masse (14) wahlweise herstellbar ist.

8. Pulserzeugungsvorrichtung (10) nach zumindest einem der vorstehenden Ansprüche,
**dadurch gekennzeichnet, dass**
das Anpasselement eine nicht-leuchtende Diode und/oder eine Leuchtdiode und bevorzugt einen ohmschen Widerstand (16) umfasst, wobei die Größe des ohmschen Widerstands (16) kleiner als der Wellenwiderstand des Verzögerungsglieds (18) ist.

9. Logikschaltung mit mehreren Logikgattern und einer Pulserzeugungsvorrichtung (10) gemäß einem der vorstehenden Ansprüche, wobei ein von der Pulserzeugungsvorrichtung (10) erzeugter Puls (P) mittels zumindest eines Logikgatters verarbeitet wird.

10. Laserscanner mit einer Pulserzeugungsvorrichtung (10) nach zumindest einem der Ansprüche 1 bis 8 mit der Laserdiode (42), welche mit von der Pulserzeugungsvorrichtung (10) erzeugten Pulsen (P) betrieben wird.

## Claims

1. A pulse generation apparatus (10) configured to generate electrical pulses (P) having pulse durations in the range of nanoseconds, wherein the electrical pulses (P) have voltages having an amount of up to 60 V and/or currents of less than 20 A, said pulse generation apparatus (10) comprising
a signal source (12) which provides an input signal;
a delay element (18) which is electrically coupled to the signal source (12, 36) and which delays a signal applied to the delay element (18) by a predetermined time period on the passing through of the delay element (18);
a reflection means (24) which reflects signals passing through the delay element (18); and
a signal output (26) for outputting the electrical pulses (P) which is electrically connected to the delay element (18),
wherein an adaptation element (16, 32, 42) is provided which brings about an adaptation of the resistance of the signal source (12, 36) and/or of the reflection means (24) to the wave impedance of the delay element, **characterized in that**
the adaptation element comprises a laser diode (42) and the signal source is a voltage source (12).

2. A pulse generation apparatus (10) in accordance with claim 1,
**characterized in that**
the signal output (26) is coupled to a level converter, in particular to a logic gate.

3. A pulse generation apparatus (10) in accordance with claim 1 or claim 2,
**characterized in that**
the delay element (18) comprises a conductor track which is arranged on a circuit board and/or in an integrated circuit (IC).

4. A pulse generation apparatus (10) in accordance with at least one of the preceding claims, **characterized in that**
the time period by which the delay element (18) delays signals passing through is adjustable, with a plurality of reflection means (24) preferably being present which are selectively electrically connectable to the delay element (18) and of which the respectively electrically connected reflection means reflects signals passing through the delay element (18).

5. A pulse generation apparatus (10) in accordance with at least one of the preceding claims, **characterized in that**
the reflection means (24) comprises a short circuit or an open line end.

6. A pulse generation apparatus (10) in accordance with at least one of the preceding claims, **characterized in that**
the signal source (12, 36) is capacitively connected to the delay element (18).

7. A pulse generation apparatus (10) in accordance with at least one of the preceding claims, **characterized in that**
the adaptation element (16, 42) comprises a switch (32), with an electrical connection to ground (14) being able to be selectively established by means of the switch (32).

8. A pulse generation apparatus (10) in accordance with at least one of the preceding claims,
**characterized in that**
the adaptation element comprises a diode which does not emit light and/or a light emitting diode and preferably an ohmic resistor (16), with the magnitude of the ohmic resistor (16) being smaller than the wave impedance of the delay element (18).

9. A logic circuit comprising a plurality of logic gates and a pulse generation apparatus (10) in accordance with any one of the preceding claims, wherein a pulse (P) generated by the pulse generation apparatus (10) is processed by means of at least one logic gate.

10. A laser scanner comprising a pulse generation apparatus (10) in accordance with at least one of the claims 1 to 8 comprising the laser diode (42) which is operated by pulses (P) generated by the pulse generation apparatus (10).

## Revendications

1. Dispositif de génération d'impulsions (10) conçu pour générer des impulsions électriques (P) ayant des durées d'impulsion dans la gamme des nanosecondes, les impulsions électriques (P) présentant des tensions pouvant aller jusqu'à 60 V et/ou des courants inférieurs à 20 A, comprenant :
une source de signal (12) fournissant un signal d'entrée ;
un élément de retard (18) couplé électriquement à la source de signal (12, 36), qui retarde un signal appliqué à l'élément de retard (18) d'une durée prédéterminée lorsque celui-ci traverse l'élément de retard (18) ;
un moyen de réflexion (24) qui réfléchit les signaux traversant l'élément de retard (18) et
une sortie de signal (26) pour délivrer les impulsions électriques (P), qui est reliée électriquement à l'élément de retard (18),
un élément d'adaptation (16, 32, 42) étant présent, qui réalise une adaptation de la résistance de la source de signal (12, 36) et/ou du moyen de réflexion (24) à l'impédance caractéristique de l'élément de retard,
**caractérisé en ce que**
l'élément d'adaptation comprend une diode laser (42) et la source de signal est une source de tension (12).

2. Dispositif de génération d'impulsions (10) selon la revendication 1,
**caractérisé en ce que**
la sortie de signal (26) est couplée à un convertisseur de niveau, en particulier une porte logique.

3. Dispositif de génération d'impulsions (10) selon la revendication 1 ou 2,
**caractérisé en ce que**
l'élément de retard (18) comprend une piste conductrice qui est disposée sur une carte de circuit imprimé et/ou dans un circuit intégré (IC).

4. Dispositif de génération d'impulsions (10) selon au moins l'une des revendications précédentes,
**caractérisé en ce que**
la durée dont l'élément de retard (18) retarde les signaux qui le traversent est réglable, plusieurs moyens de réflexion (24) étant de préférence présents, qui peuvent être reliés électriquement de manière sélective à l'élément de retard (18) et dont le moyen respectivement relié électriquement réfléchit les signaux qui traversent l'élément de retard (18).

5. Dispositif de génération d'impulsions (10) selon au moins l'une des revendications précédentes,
**caractérisé en ce que**
le moyen de réflexion (24) comprend un court-circuit ou une extrémité de ligne ouverte.

6. Dispositif de génération d'impulsions (10) selon au moins l'une des revendications précédentes,
**caractérisé en ce que**
la source de signal (12, 36) est reliée de manière capacitive à l'élément de retard (18).

7. Dispositif de génération d'impulsions (10) selon au moins l'une des revendications précédentes,
**caractérisé en ce que**
l'élément d'adaptation (16, 42) comprend un commutateur (32), une liaison électrique avec la masse (14) pouvant être établie de manière sélective au moyen du commutateur (32).

8. Dispositif de génération d'impulsions (10) selon au moins l'une des revendications précédentes,
**caractérisé en ce que**
l'élément d'adaptation comprend une diode non luminescente et/ou une diode luminescente et de préférence une résistance ohmique (16), la grandeur de la résistance ohmique (16) étant inférieure à l'impédance caractéristique de l'élément de retard (18).

9. Circuit logique comprenant plusieurs portes logiques et un dispositif de génération d'impulsions (10) selon l'une des revendications précédentes, dans lequel une impulsion (P) générée par le dispositif de génération d'impulsions (10) est traitée au moyen d'au moins une porte logique.

10. Scanner laser comprenant un dispositif de génération d'impulsions (10) selon au moins l'une des revendications 1 à 8 avec la diode laser (42) qui est commandée par des impulsions (P) générées par le dispositif de génération d'impulsions (10).
